# EUROPEAN PATENT SPECIFICATION

(11) **EP 0 546 959 B1**
(45) Date of publication and mention of the grant of the patent: **01.10.1997**
(21) Application number: 92403402.8
(22) Date of filing: 14.12.1992
(51) Int. Cl.: H01L 39/24, H01L 39/22

(54) **Superconducting device having an extremely thin superconducting channel formed of oxide superconductor material**
Supraleitendes Bauelement mit extrem dünnem supraleitendem Kanal aus supraleitendem Oxidmaterial
Dispositif supraconducteur avec un canal supraconducteur extrêmement mince formé par un matériau d'oxyde supraconducteur

(30) Priority: 13.12.1991 JP 352193/91; 13.12.1991 JP 352194/91; 13.12.1991 JP 352197/91; 20.12.1991 JP 355187/91; 10.12.1992 JP 352659/92
(43) Date of publication of application: 16.06.1993
(60) Divisional application: 97107771.4
(73) Proprietor: SUMITOMO ELECTRIC INDUSTRIES, LTD., Osaka-shi, Osaka 541 (JP)
(72) Inventor: Nakamura, Takao, F-75116 Paris (FR); Inada, Hiroshi, F-75116 Paris (FR); Iiyama, Michitomo, F-75116 Paris (FR)
(74) Representative: Ballot, Paul Denis Jacques

(56) References cited:
- EP-A- 0 475 838
- EP-A- 0 477 063
- EP-A- 0 477 103
- EP-A- 0 478 465
- EP-A- 0 505 259
- EP-A- 0 545 801
- APPLIED PHYSICS LETTERS vol. 58, no. 23, 10 June 1991, NEW YORK, US pages 2707-2709 Tarutani Y et al 'Superconducting characteristics of a planar-type HoBa2Cu307-x-La1.5Ba1.5Cu307-y-HoBa2Cu307-x junction'
- WORKSHOP ON HIGH TEMPERATURE SUPERCONDUCTING ELECTRON DEVICES June 1989, SHIKABE,JP pages 281 - 284 D.F.Moore et al 'Superconducting Thin Films for Device Applications'
- Appl.Phys.Lett. 62(6), 8 Feb.1993, pages 630-632
- Appl.Phys.Lett. 61(9), 31 Aug.1992, pages 1128-1130

## Description

### Background of the Invention

### Field of the invention

The present invention relates to a superconducting device, and more specifically to a superconducting device having an extremely thin superconducting channel formed of oxide superconductor material.

### Description of related art

Devices which utilize superconducting phenomena operate rapidly with low power consumption so that they have higher performance than conventional semiconductor devices. Particularly, by using an oxide superconducting material which has been recently advanced in study, it is possible to produce a superconducting device which operates at relatively high temperature.

Josephson device is one of well-known superconducting devices. However, since Josephson device is a two-terminal device, a logic gate which utilizes Josephson devices becomes complicated configuration. Therefore, three-terminal superconducting devices are more practical.

Typical three-terminal superconducting devices include two types of super-FET (field effect transistor). The first type of the super-FET includes a semiconductor channel, and a superconductor source electrode and a superconductor drain electrode which are formed closely to each other on both side of the semiconductor channel. A portion of the semiconductor layer between the superconductor source electrode and the superconductor drain electrode has a greatly recessed or undercut rear surface so as to have a reduced thickness. In addition, a gate electrode is formed through a gate insulating layer on the portion of the recessed or undercut rear surface of the semiconductor layer between the superconductor source electrode and the superconductor drain electrode.

A superconducting current flows through the semiconductor layer (channel) between the superconductor source electrode and the superconductor drain electrode due to the superconducting proximity effect, and is controlled by an applied gate voltage. This type of the super-FET operates at a higher speed with a low power consumption.

The second type of the super-FET includes a channel of a superconductor formed between a source electrode and a drain electrode, so that a current flowing through the superconducting channel is controlled by a voltage applied to a gate formed above the superconducting channel.

Both of the super-FETs mentioned above are voltage controlled devices which are capable of isolating output signal from input one and of having a well defined gain.

However, since the first type of the super-FET utilizes the superconducting proximity effect, the superconductor source electrode and the superconductor drain electrode have to be positioned within a distance of a few times the coherence length of the superconductor materials of the superconductor source electrode and the superconductor drain electrode. In particular, since an oxide superconductor has a short coherence length, a distance between the superconductor source electrode and the superconductor drain electrode has to be made less than about a few ten nanometers, if the superconductor source electrode and the superconductor drain electrode are formed of the oxide superconductor material. However, it is very difficult to conduct a fine processing such as a fine pattern etching, so as to satisfy the very short separation distance mentioned above.

On the other hand, the super-FET having the superconducting channel has a large current capability, and the fine processing which is required to product the first type of the super-FET is not needed to product this type of super-FET.

In order to obtain a complete ON/OFF operation, both of the superconducting channel and the gate insulating layer should have an extremely thin thickness. For example, the superconducting channel formed of an oxide superconductor material should have a thickness of less than five nanometers and the gate insulating layer should have a thickness more than ten nanometers which is sufficient to prevent a tunnel current.

In the super-FET, since the extremely thin superconducting channel is connected to the relatively thick superconducting source region and the superconducting drain region at their lower portions, the superconducting current flows substantially horizontally through the superconducting channel and substantially vertically in the superconducting source region and the superconducting drain region. Since the oxide superconductor has the largest critical current density J_{c} in the direction perpendicular to *c*-axes of its crystal lattices, the superconducting channel is preferably formed of a *c*-axis oriented oxide superconductor thin film and the superconducting source region and the superconducting drain region are preferably formed of *a*-axis oriented oxide superconductor thin films.

In a prior art, in order to manufacture the super-FET which has the superconducting channel of *c*-axis oriented oxide superconductor thin film and the superconducting source region and the superconducting drain region of *a*-axis oriented oxide superconductor thin films, a *c*-axis oriented oxide superconductor thin film is formed at first and the *c*-axis oriented oxide superconductor thin film is etched and removed excluding a portion which will be the superconducting channel. Then, an *a*-axis oriented oxide superconductor thin film is deposited so as to form the superconducting source region and the superconducting drain region.

In another prior art, at first an *a*-axis oriented oxide superconductor thin film is deposited and etched so as to form the superconducting source region and the superconducting drain region, and then a *c*-axis oriented oxide superconductor thin film is deposited so as to form the superconducting channel.

The European Patent Application N° EP-A-0 475 838 describes a superconducting device comprising a substrate coated with a non-superconducting oxide layer. In order to manufacture such a device, a first and a second superconducting regions are formed of c-axis oriented oxide superconducting thin films, deposited directly on the non-superconducting oxide layer, and are separated from each other by a third oxide superconducting region of an extremely thin thickness.

On the other hand, the European Patent Application N° EP-A-0 477 103 describes a superconducting device, in which a first oxide superconductor thin film having a very thin thickness is formed on a principal surface of a substrate, and a stacked structure of a gate insulator and a gate electrode is formed on a portion of this first thin film. Then, a first and second superconducting regions having a relatively thick thickness are formed at opposite sides of the gate electrode, and are electrically isolated from the gate electrode.

However, in the prior art, the oxide superconductor thin film is degraded during the etching so that the superconducting characteristics is affected. In addition, the etched surface of the oxide superconductor thin film is roughened, therefore, if another oxide superconductor thin film is formed so as to contact the rough surface, an undesirable Josephson junction or a resistance is generated at the interface.

By this, the super-FET manufactured by the above conventional process does not have an enough performance.

### Summary of the Invention

Accordingly, it is an object of the present invention to provide a superconducting device having a superconducting region constituted of an extremely thin oxide superconductor film, which have overcome the above mentioned defects of the conventional ones.

The above and other objects of the present invention are achieved in accordance with the present invention by a superconducting device comprising:
a substrate having a principal surface;
a superconducting source region and a superconducting drain region formed of an oxide superconductor thin film electrically isolated from each other disposed on a non-superconducting oxide layer on the principal surface of the substrate, the non-superconducting oxide layer having a crystal structure similar to that of the oxide superconductor thin film;
an extremely thin superconducting channel formed or a *c*-axis oriented oxide superconductor thin film which electrically connects the superconducting source region and the superconducting drain region,
so that superconducting current can flow through the superconducting channel between the superconducting source region and the superconducting drain region ; and
a gate electrode on a gate insulator on the superconducting channel for controlling the superconducting current flowing through the superconducting channel , wherein the superconducting source region and the superconducting drain region are formed of a *c*-axis orientated oxide superconductor thin film, and the superconducting source region the superconducting drain region have upper surfaces gently inclined to the superconducting channel by a tilt angle of less than 40°.

In the superconducting device in accordance with the present invention, upper surfaces of the first and second superconducting regions gently inclines to the third superconducting region of an extremely thin oxide superconductor thin film. Therefore, superconducting current flows into or flows from the third superconducting region efficiently so that the current capability of the superconducting device can be improved.

In the first embodiment, the third superconducting region forms a superconducting channel, so that superconducting current can flow between the first and second superconducting region through the third superconducting region. In this case, the superconducting deyice further includes a gate electrode formed on the third superconducting region, so that the superconducting device constitutes a super-FET, and the superconducting current flowing between the first and second superconducting region through the third superconducting region is controlled by a voltage applied to the gate electrode.

In the superconducting device in accordance with the present invention, the non-superconducting oxide layer preferably has a similar crystal structure to that of a *c*-axis oriented oxide superconductor thin film. In this case, the superconducting channel of a *c*-axis oriented oxide superconductor thin film can be easily formed.

Preferably, the above non-superconducting oxide layers is formed of a Pr₁Ba₂Cu₃O_{7-ε} oxide. A *c*-axis oriented Pr₁Ba₂Cu₃O_{7-ε} thin film has almost the same crystal lattice structure as that of a *c*-axis oriented oxide superconductor thin film. It compensates an oxide superconductor thin film for its crystalline incompleteness at the bottom surface. Therefore, a *c*-axis oriented oxide superconductor thin film of high crystallinity can be easily formed on the *c*-axis oriented Pr₁Ba₂Cu₃O_{7-ε} thin film. In addition, the effect of diffusion of the constituent elements of Pr₁Ba₂Cu₃O_{7-ε} into the oxide superconductor thin film is negligible and it also prevents the diffusion from substrate. Thus, the oxide superconductor thin film deposited on the Pr₁Ba₂Cu₃O_{7-ε} thin film has a high quality.

In a preferred embodiment, the oxide superconductor is formed of high-T_{c} (high critical temperature) oxide superconductor, particularly, formed of a high-T_{c} copper-oxide type compound oxide superconductor for example a Y-Ba-Cu-O compound oxide superconductor material, a Bi-Sr-Ca-Cu-O compound oxide superconductor material, and a TI-Ba-Ca-Cu-O compound oxide superconductor material.

In addition, the substrate can be formed of an insulating substrate, preferably an oxide single crystalline substrate such as MgO, SrTiO₃, CdNdAlO₄, etc. These substrate materials are very effective in forming or growing a crystalline film having a high degree of crystalline orientation. However, the superconducting device can be formed on a semiconductor substrate if an appropriate buffer layer is deposited thereon. For example, the buffer layer on the semiconductor substrate can be formed of a double-layer coating formed of a MgAlO₄ layer and a BaTiO₃ layer if silicon is used as a substrate.

According to another aspect of the present invention, there is provided a superconducting device comprising:
a substrate having a principal surface;
a non-superconducting oxide layer on the principal surface of the substrate ;
two superconducting regions formed of an oxide superconductor thin film on the non-superconducting oxide layer electrically isolated from each other, the non-superconducting oxide layer having a crystal structure similar to that of the oxide superconductor thin film ; and
an extremely thin superconducting region formed of an oxide superconductor thin film which electrically connects the two superconducting regions and forms a weak link of Josephson junction, wherein the two superconducting regions are formed of one *c*-axis oriented oxide superconductor thin film which has a gently concave upper surface with a tilt angle of less than 40° and an insulating region at its center portion including an impurity concentration sufficient to inhibit superconductivity and the extremely thin superconducting region is formed of a *c*-axis oriented oxide superconductor thin film on the insulating region.

In one preferred embodiment, the ions which are implanted so as to form the insulating region are selected from Ga ions, Al ions, In ions, Si ions, Ba ions and Cs ions.

### Brief Description of the Drawings

Figures 1A to 1F are diagrammatic sectional views for illustrating a first embodiment of the process in accordance with the present invention for manufacturing the super-FET;
Figures 2A to 2C are diagrammatic sectional views for illustrating featured steps of a second embodiment of the process in accordance with the present invention for manufacturing the super-FET;

### Description of the Preferred embodiments

### Embodiment 1

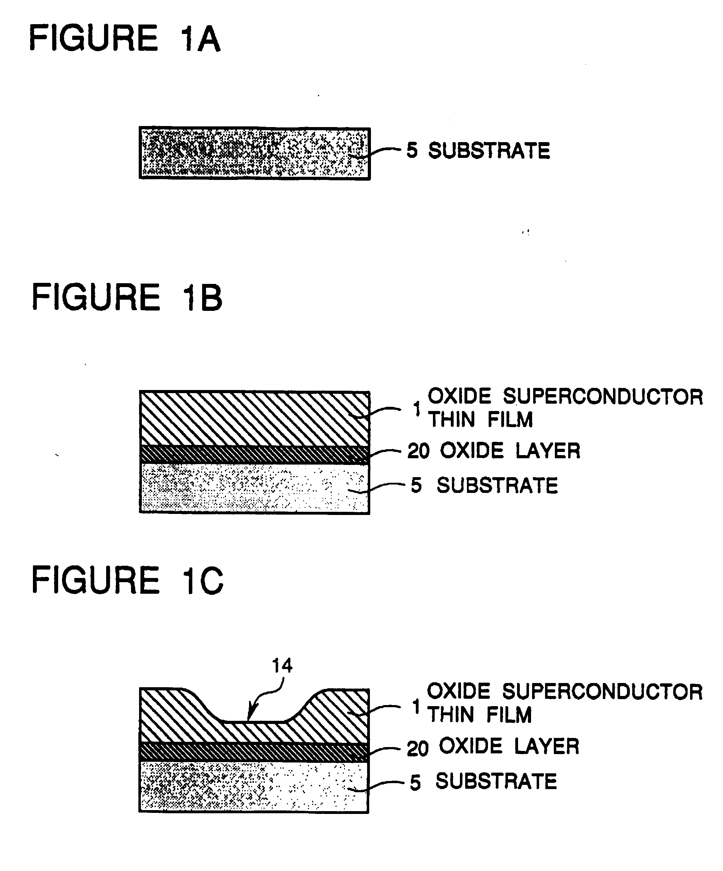

Referring to Figures 1A to 1F, the process in accordance with the present invention for manufacturing the super-FET will be described.

As shown in Figure 1A, a MgO (100) single crystalline substrate 5 having a substantially planar principal surface is prepared.

As shown in Figure 1B, an oxide layer 20 having a thickness of 100 nanometers composed of a *c*-axis oriented Pr₁Ba₂Cu₃O_{7-ε} thin film is deposited on the principal surface of the substrate 5 and a *c*-axis oriented Y₁Ba₂Cu₃O_{7-δ} oxide superconductor thin film 1 having a thickness of about 300 nanometers is deposited on the oxide layer 20, by for example a sputtering, an MBE (molecular beam epitaxy), a vacuum evaporation, a CVD, etc. A condition of forming the *c*-axis oriented Pr₁Ba₂Cu₃O_{7-ε} thin film and the *c*-axis oriented Y₁Ba₂Cu₃O_{7-δ} oxide superconductor thin film 1 by off-axis sputtering is as follows:

| Pr₁Ba₂Cu₃O_{7-ε} thin film | | |
|---|---|---|
| Temperature of the substrate | 750°C | |
| Sputtering Gas | Ar: | 90% |
| | O₂: | 10% |
| Pressure | 10 Pa | |

| Y₁Ba₂Cu₃O_{7-δ} oxide superconductor thin film | | |
|---|---|---|
| Temperature of the substrate | 700 °C | |
| Sputtering Gas | Ar: | 90% |
| | O₂: | 10% |
| Pressure | 10 Pa | |

Then, as shown in Figure 1C, a center portion of the Y₁Ba₂Cu₃O_{7-δ} oxide superconductor thin film 1 is processed by He ion-beam accelerated by an energy of 3 to 50 keV so as to form a concave portion 14 which is concave gently. The tilt angle of the concave portion 14 is less than 40° and its length is about 100 nanometers.

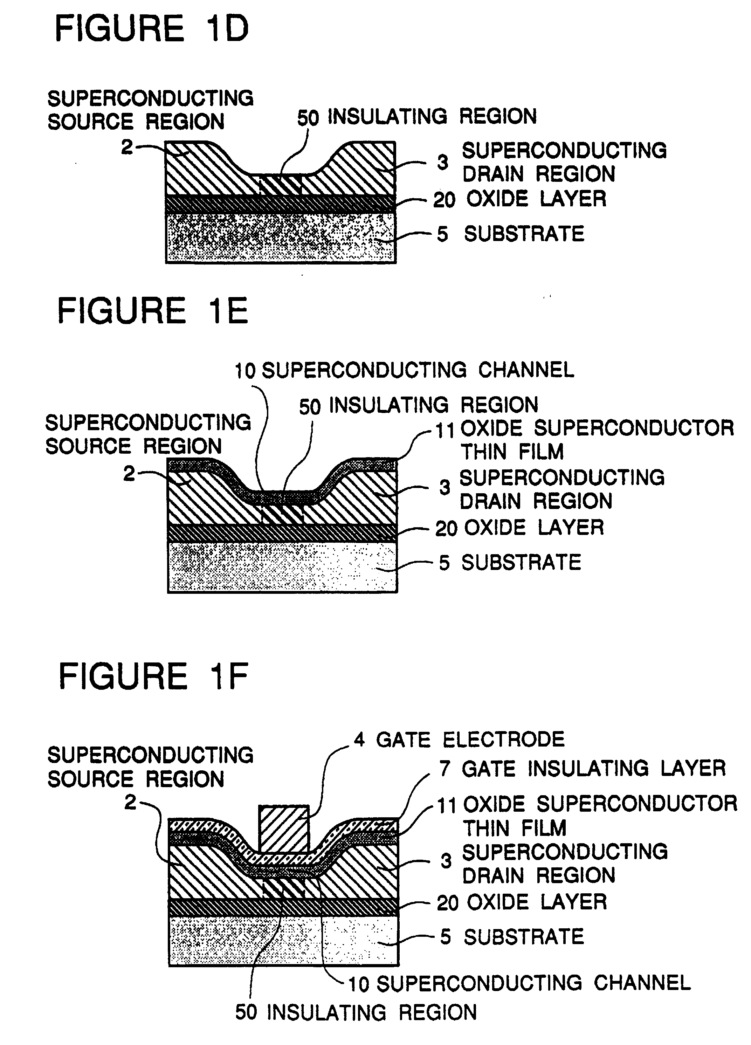

Thereafter, Ga ions are implanted into a bottom portion of the concave portion 14 by an energy of 50 to 150 keV so as to form an insulating region 50, as shown in Figure 1D. In this connection, Al ions, In ions, Si ions, Ba ions and Cs ions can be also used instead of Ga ions. The Y₁Ba₂Cu₃O_{7-δ} oxide superconductor thin film 1 is divided into a superconducting source region 2 and a superconducting drain region 3 by the insulating region 50.

Then, the substrate 5 is heated to a temperature of 350 to 400 °C under a pressure lower than 1.333 x 10⁻⁷ Pa (1 × 10⁻⁹ Torr) so as to clean the surface of the Y₁Ba₂Cu₃O_{7-δ} oxide superconductor thin film 1. This heat-treatment is not necessary, if the surface of the Y₁Ba₂Cu₃O_{7-δ} oxide superconductor thin film 1 is clean enough.

Thereafter, as shown in Figure 1E, a *c*-axis oriented Y₁Ba₂Cu₃O_{7-δ} oxide superconductor thin film 11 having a thickness on the order of about 5 nanometers is deposited on the surface of the Y₁Ba₂Cu₃O_{7-δ} oxide superconductor thin film 1 by an MBE (molecular beam epitaxy). A condition of forming the *c*-axis oriented Y₁Ba₂Cu₃O_{7-δ} oxide superconductor thin film 11 by an MBE is as follows:

| | | |
|---|---|---|
| Molecular beam source | Y: | 1250°C |
| | Ba: | 600°C |
| | Cu: | 1040°C |
| | | |
| O₂ or O₃ atmosphere | | |
| Pressure | 1.333 x 10⁻³ Pa (1 × 10⁻⁵ Torr) | |
| Temperature of the substrate | 700°C | |

Since the Y₁Ba₂Cu₃O_{7-δ} oxide superconductor thin film 11 is formed on the gently curved surface of the Y₁Ba₂Cu₃O_{7-δ} oxide superconductor thin film 1, it becomes an uniform *c*-axis oriented oxide superconductor thin film. A portion of the Y₁Ba₂Cu₃O_{7-δ} oxide superconductor thin film 11 on the insulating region 50 becomes a superconducting channel.

Finally, as shown in Figure 1F, a gate insulating layer 7 is formed of Si₃N₄, MgO or SrTiO₃ on the superconducting channel 10 and a gate electrode 4 is formed of Au on the gate insulating layer 7. Metal electrodes may be formed on the superconducting source region 2 and the superconducting drain region 3, if necessary. With this, the super-FET in accordance with the present invention is completed.

As explained above, the superconducting channel, the superconducting source region and the superconducting drain region of the above mentioned super-FET manufactured in accordance with the embodiment of the method of the present invention are formed of *c*-axis oriented oxide superconductor thin films. Therefore, the super-FET has no undesirable resistance nor undesirable Josephson junction between the superconducting channel and the superconducting source region and between the superconducting channel and the superconducting drain region. In addition, since the superconducting source region and the superconducting drain region gently inclines to the superconducting channel, superconducting current efficiently flows into and flows from the superconducting channel. By this, the current capability of the super-FET can be improved.

In the above method, if the Y₁Ba₂Cu₃O_{7-δ} oxide superconductor thin film 11 is deposited to have a grain boundary so as to form a weak link of the Josephson junction on the insulating region 50, a Josephson junction device is manufactured. In this case, the superconducting source region and the superconducting drain region are two superconducting electrodes. Almost all the above mentioned features of the super-FET can apply to the Josephson junction device.

### Embodiment 2

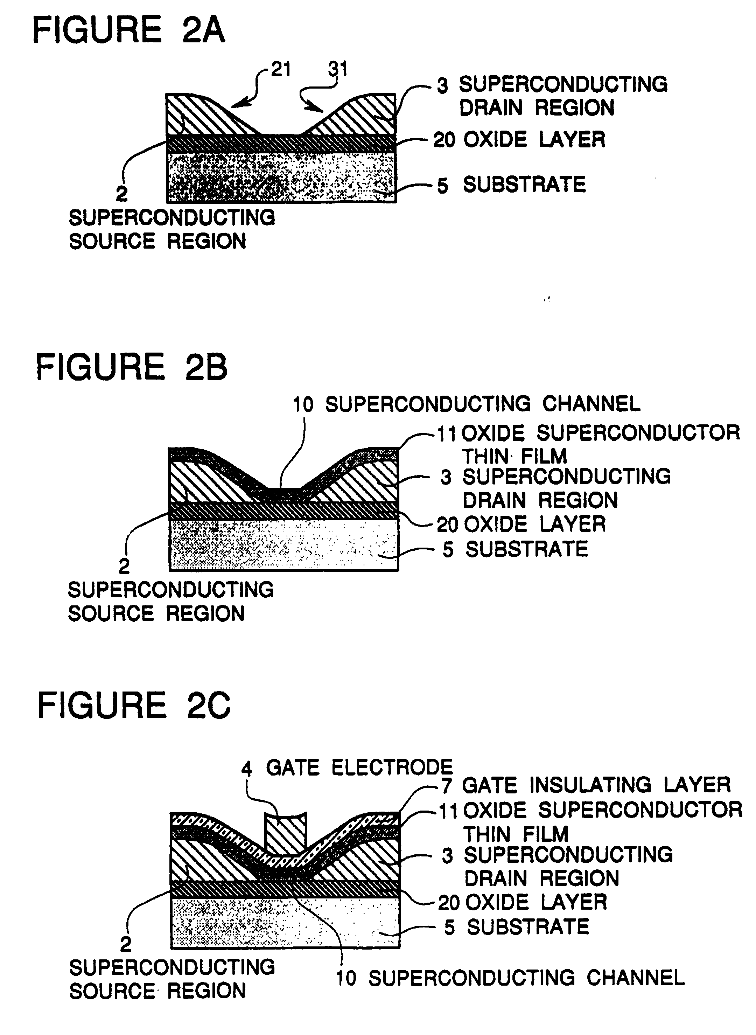

Referring to Figures 2A to 2C, a second embodiment of the process for manufacturing the superconducting device will be described.

In this second embodiment, the same processings as those shown in Figures 1A to 1B are performed.

Then, as shown in Figure 2A, the Y₁Ba₂Cu₃O_{7-δ} oxide superconductor thin film 1 is processed by He ion-beam accelerated by an energy of 3 to 50 keV so that the Y₁Ba₂Cu₃O_{7-δ} oxide superconductor thin film 1 is divided into a superconducting source region 2 and a superconducting drain region 3 which have inclined surfaces gently inclined to each other. The tilt angle of the inclined surfaces is less than 40°. The oxide layer 20 of Pr₁Ba₂Cu₃O_{7-ε} is exposed between the superconducting source region 2 and the superconducting drain region 3.

Then, the substrate 5 is heated to a temperature of 350 to 400 °C under a pressure lower than 1.333 x 10⁻⁷ Pa (1 × 10⁻⁹ Torr) so as to clean the surfaces of the superconducting source region 2 and the superconducting drain region 3 and the exposed surface of the oxide layer 20. This heat-treatment is not necessary, if the surfaces of the superconducting source region 2 and the superconducting drain region 3 and the exposed surface of the oxide layer 20 are clean enough.

Thereafter, as shown in Figure 2B, a *c*-axis oriented Y₁Ba₂Cu₃O_{7-δ} oxide superconductor thin film 11 having a thickness on the order of about 5 nanometers is deposited on the surfaces of the superconducting source region 2 and the superconducting drain region 3 and the exposed surface of the oxide layer 20 by an MBE (molecular beam epitaxy). A condition of forming the *c*-axis oriented Y₁BA₂Cu₃O_{7-δ} oxide superconductor thin film 11 by an MBE is the same as that of Embodiment 1.

Since the Y₁Ba₂Cu₃O_{7-δ} oxide superconductor thin film 11 is formed on the gently curved surfaces of the superconducting source region 2 and the superconducting drain region 3 and the exposed surface of the oxide layer 20, it becomes an uniform *c*-axis oriented oxide superconductor thin film. A portion of the Y₁Ba₂Cu₃O_{7-δ} oxide superconductor thin film 11 on the exposed surface of the oxide layer 20 becomes a superconducting channel 10.

Finally, as shown in Figure 2C, a gate insulating layer 7 is formed of Si₃N₄, MgO or SrTiO₃ on the superconducting channel 10 and a gate electrode 4 is formed of Au on the gate insulating layer 7. Metal electrodes may be formed on the superconducting source region 2 and the superconducting drain region 3, if necessary. With this, the super-FET in accordance with the present invention is completed.

As explained above, the superconducting channel, the superconducting source region and the superconducting drain region of the above mentioned super-FET manufactured in accordance with the embodiment of the method of the present invention are formed of *c*-axis oriented oxide superconductor thin films. Therefore, the super-FET has no undesirable resistance nor undesirable Josephson junction between the superconducting channel and the superconducting source region and between the superconducting channel and the superconducting drain region. In addition, since the superconducting source region and the superconducting drain region gently inclines to the superconducting channel, superconducting current efficiently flows into and flows from the superconducting channel. By this, the current capability of the super-FET can be improved.

In the above method, if the Y₁Ba₂Cu₃O_{7-δ} oxide superconductor thin film 11 is deposited to have a grain boundary so as to form a weak link of the Josephson junction on the exposed surface of the oxide layer 20, a Josephson junction device is manufactured. In this case, the superconducting source region and the superconducting drain region are two superconducting electrodes. Almost all the above mentioned features of the super-FET can apply to the Josephson junction device.

## Claims

1. A superconducting device, comprising:
a substrate (5) having a principal surface;
a superconducting source region (2) and a superconducting drain region (3) formed of an oxide superconductor thin film electrically isolated from each other disposed on a non-superconducting oxide layer (20) on the principal surface of the substrate (5), the non-superconducting oxide layer having a crystal structure similar to that of the oxide superconductor thin film ;
an extremely thin superconducting channel (10) formed of a *c*-axis oriented oxide superconductor thin film which electrically connects the superconducting source region (2) and the superconducting drain region (3), so that superconducting current can flow through the superconducting channel (10) between the superconducting source region (2) and the superconducting drain region (3); and
a gate electrode (4) on a gate insulator (7) on the superconducting channel (10) for controlling the superconducting current flowing through the superconducting channel (10), wherein the superconducting source region (2) and the superconducting drain region (3) are formed of a *c*-axis orientated oxide superconductor thin film, and the superconducting source region (2) and the superconducting drain region (3) have upper surfaces gently inclined to the superconducting channel by a tilt angle of less than 40°.

2. A superconducting device as claimed in Claim 1, **characterized in that** the superconducting source region (2) and the superconducting drain region (3) are formed of one *c*-axis oriented oxide superconductor thin film (1) which has a gently concave upper surface (14) and an insulating region (50) at its center portion including an impurity concentration sufficient to inhibit superconductivity.

3. A superconducting device as claimed in Claim 1, **characterized in that** the superconducting channel (10) is formed on the non-superconducting oxide layer (20).

4. A superconducting device, comprising:
a substrate (5) having a principal surface;
a non-superconducting oxide layer (20) on the principal surface of the substrate (5);
two superconducting regions (2, 3) formed of an oxide superconductor thin film on the non-superconducting oxide layer (20) electrically isolated from each other, the non-superconducting oxide layer (20) having a crystal structure similar to that of the oxide superconductor thin film ; and
an extremely thin superconducting region (10) formed of an oxide superconductor thin film which electrically connects the two superconducting regions (2, 3) and forms a weak link of Josephson junction, wherein the two superconducting regions (2, 3) are formed of one *c*-axis oriented oxide superconductor thin film (1) which has a gently concave upper surface (14) with a tilt angle of less than 40° and an insulating region (50) at its center portion including an impurity concentration sufficient to inhibit superconductivity and the extremely thin superconducting region (10) is formed of a *c*-axis oriented oxide superconductor thin film on the insulating region (50).

5. A superconducting device as claimed in anyone of Claims 1 or 4, **characterized in that** the non-superconducting oxide layer (20) has a similar crystal structure to that of a *c*-axis oriented oxide superconductor thin film.

6. A superconducting device as claimed in claim 5, **characterized in that** the non-superconducting oxide layer (20) is formed of a Pr₁Ba₂Cu₃O_{7-ε} thin film.

7. A superconducting device as claimed in anyone of Claims 1 to 5, **characterized in that** the oxide superconductor is a high-T_{c} (high critical temperature) oxide superconductor.

8. A superconducting device as claimed in Claim 7, **characterized in that** the oxide superconductor is a high-T_{c} copper-oxide type compound oxide superconductor.

9. A superconducting device as claimed in Claim 8, **characterized in that** the oxide superconductor is an oxide superconductor material selected from the group consisting of a Y-Ba-Cu-O compound oxide superconductor material, a Bi-Sr-Ca-Cu-O compound oxide superconductor material, and a Tl-Ba-Ca-Cu-O compound oxide superconductor material.

10. A superconducting device as claimed in anyone of Claims 1 to 9, **characterized in that** the substrate is formed of a material selected from the group consisting of a MgO (100) substrate, a SrTiO₃ (100) substrate and a CdNdAlO₄ (001) substrate, and a semiconductor substrate.

11. A superconducting device as claimed in Claim 10, **characterized in that** the substrate is formed of a silicon substrate and a principal surface of the silicon substrate is coated with an insulating material layer which is formed of a MgAl₂O₄ layer and a BaTiO₃ layer.

## Patentansprüche

1. Supraleitendes Bauelement mit:
einem Substrat (5), welches eine Hauptoberfläche aufweist;
einem supraleitenden Source-Bereich (2) und einem supraleitenden Drain-Bereich (3), die aus einer dünnen supraleitenden Dünnschicht ausgebildet sind und voneinander elektrisch isoliert sind und auf einer nicht-supraleitenden Oxidschicht (20) auf der Hauptoberfläche des Substrats (5) angeordnet sind, wobei die nicht-supraleitende Oxidschicht eine Kristallstruktur aufweist, die derjenigen der oxidischen supraleitenden Dünnschicht ähnlich ist;
einem äußerst dünnen supraleitenden Kanal (10), der aus einer oxidischen supraleitenden Dünnschicht mit c-Achsausrichtung ausgebildet ist, der den supraleitenden Source-Bereich (2) und den supraleitenden Drain-Bereich (3) derart elektrisch miteinander verbindet, dass ein Supraleitungsstrom durch den supraleitenden Kanal (10) zwischen dem supraleitenden Source-Bereich (2) und dem supraleitenden Drain-Bereich (3) fließen kann; und mit
einer Gate-Elektrode (4) auf einem Gate-Isolator (7) auf dem supraleitenden Kanal (10) zur Steuerung des Supraleitungsstromes, der durch den supraleitenden Kanal (10) fließt, wobei der supraleitende Source-Bereich (2) und der supraleitende Drain-Bereich (3) aus einer oxidischen supraleitenden Dünnschicht mit c-Achsausrichtung ausgebildet sind und der supraleitende Source-Bereich (2) und der supraleitende Drain-Bereich (3) obere Oberflächen aufweisen, die leicht in Richtung des supraleitenden Kanals (10) geneigt sind, mit einem Neigungswinkel von weniger als 40°.

2. Supraleitendes Bauelement nach Anspruch 1, dadurch gekennzeichnet, dass der supraleitende Source-Bereich (2) und der supraleitende Drain-Bereich (3) aus einer oxidischen supraleitenden Dünnschicht mit c-Achsausrichtung (1) ausgebildet werden, die eine leicht konkave obere Oberfläche (14) und an ihrem Mittenabschnitt einen isolierenden Bereich (50) aufweist, der eine ausreichende Störstellenkonzentration enthält, um Supraleitung zu verhindern.

3. Supraleitendes Bauelement nach Anspruch 1, dadurch gekennzeichnet, dass der supraleitende Kanal (10) auf der nicht-supraleitenden Oxidschicht (20) ausgebildet ist.

4. Supraleitendes Bauelement mit:
einem Substrat (5), welches eine Hauptoberfläche aufweist;
einer nicht-supraleitenden Oxidschicht (20) auf der Hauptoberfläche des Substrats (5);
zwei supraleitenden Bereichen (2, 3), die auf der nicht-supraleitenden Oxidschicht (20) aus einer oxidischen supraleitenden Dünnschicht ausgebildet sind und voneinander elektrisch isoliert sind, wobei die nicht-supraleitende Oxidschicht (20) eine Kristallstruktur aufweist, die derjenigen der oxidischen supraleitenden Dünnschicht ähnlich ist;
einem äußerst dünnen supraleitenden Bereich (10), der aus einer oxidischen supraleitenden Dünnschicht ausgebildet ist und der die beiden supraleitenden Bereiche (2, 3) elektrisch miteinander verbindet und eine schwache Josephson-Übergang-Verbindung bildet, wobei die zwei supraleitenden Bereiche (2, 3) aus einer oxidischen supraleitenden Dünnschicht mit c-Achsausrichtung (1) ausgebildet werden, die eine leicht konkave obere Oberfläche (14) mit einem Neigungswinkel von weniger als 40° und einen isolierenden Bereich (50) an ihrem Mittenabschnitt aufweist, der eine ausreichende Störstellenkonzentration enthält, um Supraleitung zu verhindern und wobei der äußerst dünne supraleitende Bereich (10) aus einer oxidischen supraleitenden Dünnschicht mit *c*-Achsausrichtung auf dem isolierenden Bereich (50) ausgebildet wird.

5. Supraleitendes Bauelement nach Anspruch 1 oder 4, dadurch gekennzeichnet, dass die nicht-supraleitende Oxidschicht (20) eine Kristallstruktur aufweist, die derjenigen einer oxidischen supraleitenden Dünnschicht mit *c*-Achsausrichtung ähnlich ist.

6. Supraleitendes Bauelement nach Anspruch 5, dadurch gekennzeichnet, dass die nicht-supraleitende Oxidschicht (20) aus einer Pr₁Ba₂Cu₃O_{7-ε}- Dünnschicht ausgebildet ist.

7. Supraleitendes Bauelement nach einem der Ansprüche 1 bis 5, dadurch gekennzeichnet, dass der oxidische Supraleiter ein hoch-Tc (hohe kritische Temperatur) oxidischer Supraleiter ist.

8. Supraleitendes Bauelement nach Anspruch 7, dadurch gekennzeichnet, dass der oxidische Supraleiter ein hoch-Tc supraleitendes Verbundoxid des Kupferoxid-Typs ist.

9. Supraleitendes Bauelement nach Anspruch 7, dadurch gekennzeichnet, dass der oxidische Supraleiter aus einem oxidischen Supraleitermaterial besteht, das aus einer Gruppe ausgesucht ist, die aus einem supraleitenden Y-Ba-Cu-O-Verbundoxidmaterial, aus einem supraleitenden Bi-Sr-Ca-Cu-O-Verbundoxidmaterial und aus einem supraleitenden Tl-Ba-Ca-Cu-O-Verbundoxidmaterial besteht.

10. Supraleitendes Bauelement nach einem der Ansprüche 1 bis 9, dadurch gekennzeichnet, dass das Substrat aus einem Material ausgebildet ist, das aus einer Gruppe ausgesucht ist, die aus einem MgO(100)-Substrat, einem SrTiO₃(100)-Substrat und einem CdNdAlO₄(100)-Substrat sowie aus einem Halbleitersubstrat besteht.

11. Supraleitendes Bauelement nach Anspruch 10, dadurch gekennzeichnet, dass das Substrat aus einem Silizium-Substrat ausgebildet ist und dass eine Hauptoberfläche des Silizium-Substrats mit einem isolierenden Material beschichtet ist, welches aus einer MgAl₂O₄-Schicht und einer BaTiO₃-Schicht gebildet ist.

## Revendications

1. Dispositif supraconducteur comprenant :
un substrat (5) comportant une surface principale;
une zone de source supraconductrice (2) et une zone de drain supraconductrice (3) formées d'un film mince d'oxyde supraconducteur, isolées électriquement l'une de l'autre, disposées sur une couche d'oxyde non-supraconducteur (20) sur la surface principale du substrat (5) , la couche d'oxyde non-supraconducteur possédant une structure cristalline semblable à celle du film mince d'oxyde supraconducteur ;
un canal supraconducteur extrêmement mince (10) formé d'un film mince d'oxyde supraconducteur orienté selon l'axe c qui connecte électriquement la zone de source supraconductrice (2) et la zone de drain supraconductrice (3), de sorte qu'un courant supraconducteur peut circuler à travers le canal supraconducteur (10) entre la zone de source supraconductrice (2) et la zone de drain supraconductrice (3) ; et
une électrode de grille (4) située sur un isolateur de grille (7) sur le canal supraconducteur (10) pour commander le courant supraconducteur circulant à travers le canal supraconducteur (10), dans lequel la zone de source supraconductrice (2) et la zone de drain supraconductrice (3) sont formées d'un film mince d'oxyde supraconducteur orienté selon l'axe c, et la zone de source supraconductrice (2) et la zone de drain supraconductrice (3) présentent des surfaces supérieures légèrement inclinées vers le canal supraconducteur suivant un angle d'inclinaison inférieur à 40°.

2. Dispositif supraconducteur selon la revendication 1 , caractérisé en ce que la zone de source supraconductrice (2) et la zone de drain supraconductrice (3) sont formées d'un film mince d'oxyde supraconducteur orienté selon l'axe c (1) qui présente une surface supérieure légèrement concave (14) et une zone isolante (50) au niveau de sa partie centrale comprenant une concentration en impuretés suffisante pour empêcher la supraconductivité.

3. Dispositif supraconducteur selon la revendication 1, caractérisé en ce que le canal supraconducteur (10) est formé sur la couche d'oxyde non-supraconducteur (20).

4. Dispositif supraconducteur, comprenant :
un substrat (5) comportant une surface principale;
une couche d'oxyde non-supraconducteur (20) sur la surface principale du substrat (5) ;
deux zones supraconductrices (2, 3) formées d'un film mince d'oxyde supraconducteur sur la couche d'oxyde non-supraconducteur (20), isolées électriquement l'une de l'autre , la couche d'oxyde non-supraconducteur (20) présentant une structure cristalline similaire à celle du film mince d'oxyde supraconducteur; et
une zone supraconductrice extrêmement mince (10) formée d'un film mince d'oxyde supraconducteur qui connecte électriquement les deux zones supraconductrices (2, 3) et forme une liaison faible de la jonction Josephson, dans lequel les deux zones supraconductrices (2,3) sont formées d'un film mince d'oxyde supraconducteur orienté selon l'axe c (1) qui présente une surface supérieure légèrement concave (14) , avec un angle d'inclinaison inférieur à 40°, et d'une zone isolante (50) au niveau de sa partie centrale comprenant une concentration en impuretés suffisante pour empêcher la supraconductivité et la zone supraconductrice extrêmement mince (10) est formée d'un film mince d'oxyde supraconducteur orienté selon l'axe c sur la zone isolante (50).

5. Dispositif supraconducteur selon l'une quelconque des revendications 1 ou 4, caractérisé en ce que la couche d'oxyde non-supraconducteur (20) présente une structure cristalline semblable à celle d'un film mince d'oxyde supraconducteur orienté selon l'axe c.

6. Dispositif supraconducteur selon la revendication 5 , caractérisé en ce que la couche d'oxyde non-supraconducteur (20) est formée d'un film mince de Pr₁Ba₂Cu₃O_{7-ε}.

7. Dispositif supraconducteur selon l'une quelconque des revendications 1 à 5, caractérisé en ce que l'oxyde supraconducteur est un oxyde supraconducteur à T_{c} élevée (température critique élevée).

8. Dispositif supraconducteur selon la revendication 7 , caractérisé en ce que l'oxyde supraconducteur est un supraconducteur d'oxyde composé, du type oxyde de cuivre, à T_{c} élevée.

9. Dispositif supraconducteur selon la revendication 8 , caractérisé en ce que l'oxyde supraconducteur est un matériau d'oxyde supraconducteur sélectionné dans le groupe constitué d'un matériau supraconducteur d'oxyde composé Y-Ba-Cu-O, d'un matériau supraconducteur d'oxyde composé Bi-Sr-Ca-Cu-O et d'un matériau supraconducteur d'oxyde composé Tl-Ba-Ca-Cu-O.

10. Dispositif supraconducteur selon l'une quelconque des revendications 1 à 9, caractérisé en ce que le substrat est formé d'un matériau sélectionné dans le groupe constitué d'un substrat de MgO(100) , d'un substrat de SrTiO₃ (100) et d'un substrat de CdNdAlO₄ (001) , et d'un substrat semi-conducteur.

11. Dispositif supraconducteur selon la revendication 10 , caractérisé en ce que le substrat est formé d'un substrat de silicium et en ce qu'une surface principale du substrat de silicium est recouverte d'une couche de matériau isolant qui est formé d'une couche de MgAl₂O₄ et d'une couche de BaTiO₃.
